# EUROPÄISCHE PATENTSCHRIFT

(11) **EP 0 803 919 B1**
(45) Veröffentlichungstag und Bekanntmachung des Hinweises auf die Patenterteilung: **13.06.2001**
(21) Anmeldenummer: 96106552.1
(22) Anmeldetag: 25.04.1996
(51) Int. Cl.: H01L 41/22

(54) **Verfahren zum Herstellen einer Metallisierung auf piezoelektrischen Substraten**
Method of manufacturing a metallisation on a piezoelectric substrate
Procédé pour la formation d'une métallisation sur un substrat piezoélectrique

(43) Veröffentlichungstag der Anmeldung: 29.10.1997
(73) Patentinhaber: EPCOS AG, 81541 München (DE)
(72) Erfinder: Eissler, Dieter, Dr. rer. nat., 81737 München (DE); Hartel, Christoph, Dipl.-Ing. (FH), 81377 München (DE); Knauer, Ulrich, Dr. re. nat., 81739 München (DE)
(74) Vertreter: Epping, Wilhelm, Dipl.-Ing.

(56) Entgegenhaltungen:
- US-A- 4 445 066
- US-A- 5 233 261
- PATENT ABSTRACTS OF JAPAN vol. 94, no. 012 & JP-A-06 350379 (TDK CORP), 22.Dezember 1994,
- PATENT ABSTRACTS OF JAPAN vol. 017, no. 328 (E-1385), 22.Juni 1993 & JP-A-05 037283 (TDK CORP), 12.Februar 1993,
- PATENT ABSTRACTS OF JAPAN vol. 014, no. 213 (E-0923), 7.Mai 1990 & JP-A-02 048811 (MITSUBISHI ELECTRIC CORP), 19.Februar 1990,
- PATENT ABSTRACTS OF JAPAN vol. 013, no. 164 (E-745), 19.April 1989 & JP-A-63 316912 (NIPPON DEMPA KOGYO CO LTD), 26.Dezember 1988,

## Beschreibung

Die Erfindung betrifft ein Verfahren zum Herstellen einer Metallisierung auf piezoelektrischen Substraten für Oberflächenwellen-Bauelemente.

Derartige Metallisierungen sind aus dem Stand der Technik bekannt.

In "Thin Solid Films", 16(1973) S. 227-236 sind beispielsweise Al-Cu-Metallisierungen angeführt. Weiterhin sind in "Jpn. J. Appl. Phys.", Vol.32(1993), S. 2351-2354 Al-Ti-Legierungen beschrieben. Die angeführten Metallisierungen werden zur Leistungserhöhung von Oberflächenwellen-Bauelementen benutzt.

Es wurden auch Versuche unternommen, epitaktische dotierte und undotierte Schichten herzustellen ("Electronics and Communications in Japan", Part 3, Vol. 76, No. 10, 1993, S. 33-42) und Bekeimungen zur Verbesserung der Epitaxie wurden auch vorgeschlagen ("NEC Res. § Develop.", Vol. 35, No. 2, April 1994, S.156-164).

Alle bekannten Metallisierungen weisen jedoch unter ungünstigen Betriebsbedingungen unter Umständen nicht die erforderliche Festigkeit gegen Akusto- beziehungsweise Elektromigration auf. Diese Akusto- beziehungsweise Elektromigration wird durch eine angelegte hohe elektrische Leistung bedingt.

Aus der US-4 445 066 ist eine Elektrodenstruktur für einen Zinkoxidfilm bekannt, die aus einer Titangrundschicht und einer Aluminiumelektrode besteht. Aus der US-5 233 261 ist ein Mehrschichtaufbau über einem Quarzsubstrat bekannt, bei dem unter einer Zinkschicht eine Titanhaftvermittlerschicht vorgesehen ist. Aus der JP-A-2-048811 ist es bekannt, zwischen dem piezoelektrischen Substrat und der aus Aluminium bestehenden Elektrode eines OFW-Bauelements eine Titanhaftvermittlerschicht vorzusehen.

Aufgabe der vorliegenden Erfindung ist es, ein Verfahren zur Herstellung einer zwei- beziehungsweise mehrlagigen Metallisierung für Oberflächenwellen-Bauelemente anzugeben, das eine hohe Festigkeit gegen Akusto- beziehungsweise Elektromigration gewährleistet und damit zur Erhöhung der Lebensdauer und Zuverlässigkeit elektrischer Oberflächenwellen-Bauelemente führt.

Diese Aufgabe wird erfindungsgemäß mit einem Verfahren nach Anspruch 1 gelöst.

Vorteilhafte Ausgestaltungen des Gegenstandes der Erfindung sind in den Unteransprüchen angeführt.

Dabei wird zunächst eine dünne, geschlossene und mechanisch stabile Grundschicht aus einem mit dem Substrat reagierenden Metall oder einer Metallegierung in üblicher Dünnschichttechnologie auf das Substrat aufgebracht und anschließend auf diese Grundschicht eine Schicht: aus Aluminium oder einer Aluminiumlegierung aufgebracht. Über dem so erzeugten Schichtaufbau wird eine Deckschicht aufgebracht, wobei für Grund-und Deckschicht Titan verwendet wird.

Die Erfindung wird im folgenden anhand von Ausführungsbeispielen erläutert.

Auf einem piezoelektrischen unbeheizten Substrat wie zum Beispiel Quarz, LiTaO₃ oder LiNbO₃ wird nach der üblichen Reinigung eine dünne geschlossene mechanisch stabile Grundschicht der Dicke d≥15nm aufgebracht. Die Grundschicht besteht aus einem Metall, insbesondere Titan, oder einer Legierung, die mit dem Substrat reagiert und wird in üblicher Dünnschichttechnologie aufgebracht (keine einfache Haftschicht oder Bekeimung). Auf diese Grundschicht wird die eigentliche Leitschicht aus Aluminium in einer Dicke d≥80nm aufgebracht, wobei sich diese Leitschicht wiederum hervorragend mit der Grundschicht verbindet.

Oberflächenwellen-Bauelemente mit einer Metallisierung gemäß der Erfindung zeigen gegenüber herkömmlich metallisierten Oberflächenwellen-Bauelementen mit einer Metallisierung aus einer Al-Cu-Legierung eine wesentlich erhöhte Leistungsver träglichkeit und eine längere Lebensdauer, was auf ein wesentlich verbessertes Verhalten gegenüber Akusto- beziehungsweise Elektromigration zurückzuführen ist.

Auf der Grundschicht kann auch zunächst eine Zwischenschicht aufgebracht werden. Die Zwischen schicht kann ebenfalls aus Titan oder einem anderen geeigneten Metall oder einer Metallegierung bestehen.

Die Weiterverarbeitung der Oberflächenwellen-Bauelemente, wie das Vereinzeln und der Aufbau kann in bekannter Weise erfolgen.

## Patentansprüche

1. Verfahren zum Herstellen eines Oberflächenwellen-Bauelements,
bei dem auf einem piezoelektrischen Substrat zunächst eine dünne, geschlossene und mechanisch stabile Grundschicht aus einem mit dem Substrat reagierenden Metall oder einer Metallegierung in üblicher Dünnschichttechnologie auf das Substrat aufgebracht wird,
bei dem anschließend auf diese Grundschicht eine Schicht aus Aluminium oder einer Aluminiumlegierung aufgebracht wird und bei dem auf den Schichtaufbau eine metallische Deckschicht aufgebracht wird, wobei als Werkstoff für die Grundschicht und die Deckschicht Titan verwendet wird.

2. Verfahren nach Anspruch 1,
bei dem die Grundschicht in einer Dicke ≥15nm auf das Substrat aufgebracht wird.

3. Verfahren nach einem der Ansprüche 1 oder 2,
bei dem die Schicht aus Aluminium oder der Aluminiumlegierung in einer Dicke ≥80nm aufgebracht wird.

4. Verfahren nach einem der Ansprüche 1 bis 4,
bei dem ein piezoelektrisches Substrat aus Quarz, LiTaO₃ oder LiNbO₃ verwendet wird.

## Claims

1. Method for producing a surface acoustic wave component,
in which a thin, closed and mechanically robust basic layer composed of a metal which reacts with the substrate or of a metal alloy is first of all applied to a piezoelectric substrate using conventional thin-film technology,
in which a layer composed of aluminium or aluminium alloy is then applied to this basic layer, and
in which a metallic covering layer is applied to the layer structure, with titanium being used as the material for the basic layer and for the covering layer.

2. Method according to Claim 1,
in which the basic layer is applied with a thickness of ≥15 nm to the substrate.

3. Method according to one of Claims 1 or 2,
in which the layer composed of aluminium or aluminium alloy is applied with a thickness of ≥80 nm.

4. Method according to one of Claims 1 to 3,
in which a piezoelectric substrate composed of quartz, LiTaO₃ or LiNbO₃ is used.

## Revendications

1. Procédé de fabrication d'un composant à onde de surface,
dans lequel on dépose sur un substrat piézoélectrique d'abord une mince couche de base, fermée et stable mécaniquement, en un métal réagissant sur le substrat ou en un alliage métallique réagissant sur le substrat par la technologie habituelle en couche mince,
dans lequel on dépose ensuite sur cette couche de base, une couche en aluminium ou en un alliage d'aluminium et
dans lequel on dépose sur la structure stratifiée une couche métallique de finition en utilisant comme matériau pour la couche de base et la couche de finition du titane.

2. Procédé suivant la revendication 1,
dans lequel on dépose la couche de base sur le substrat en une épaisseur supérieure ou égale à 15 nm.

3. Procédé suivant l'une des revendications 1 ou 2,
dans lequel on dépose la couche en aluminium ou en alliage d'aluminium en une épaisseur supérieure ou égale à 80 nm.

4. Procédé suivant l'une des revendications 1 à 3,
dans lequel on utilise un substrat piézoélectrique en quartz, en LiTaO₃ ou en LiNbO₃.
